# EUROPEAN PATENT APPLICATION

(11) **EP 1 517 185 A1**
(43) Date of publication of application: **23.03.2005**
(21) Application number: 04077126.3
(22) Date of filing: 22.07.2004
(51) Int. Cl.: G03F 7/20

(54) **Lithographic apparatus, device manufacturing method, and device manufactured thereby**

(30) Priority: 22.07.2003 EP 03077308; 22.12.2003 US 740822
(71) Applicant: ASML Netherlands B.V., 5504 DR Veldhoven (NL)
(72) Inventor: Loopstra, Erik Roelof, 5591 BA Heeze (NL); van de Ven, Bastiaan Lambertus Wilhelmus Marinus, 5211 GP 's-Hertogenbosch (NL); Heerens, Gert-Jan, 2871 ZH Schoonhoven (NL); Lansbergen, Robert Gabriel Maria, 3121 XR Schiedam (NL); Leenders, Martinus Hendrikus Antonius, 3039 ER Rotterdam (NL)
(74) Representative: Barendregt, Frank, Drs.

(57) **Abstract**

The invention pertains to a lithographic apparatus comprising a radiation system for providing a projection beam of radiation, a patterning means (1) serving to pattern the projection beam according to a desired pattern, thus creating a patterned beam, a support structure for supporting the patterning means (1), the support structure comprising a reticle stage and a projection system for projecting the patterned beam onto a target portion of a substrate.

According to the first aspect of the invention, the lithographic apparatus further comprises a docking system for positioning the patterning means (1) relative to the reticle stage. The lithographic projection apparatus has an operational cycle comprising a projection phase, in which the projection system projects the patterned beam onto a target portion of the substrate, and in which the reticle stage carries the patterning means (1) and an exchange phase in which the patterning means (1) is exchanged, and in which the docking system positions the patterning means (1) relative to the reticle stage.

The lithographic apparatus according to the first aspect of the invention is characterized in that the docking system is spaced from the patterning means (1) during the projection phase. This way, a higher accuracy of the projected image is obtained.

## Description

The present invention relates to a lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired;
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required; and
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper or step-and-repeat apparatus. In an alternative apparatus ― commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, both incorporated herein by reference.

The operational sequence of a lithographic apparatus comprises a projection phase, in which the projection system is active. During the projection phase, a substrate, such as a wafer, is exposed. During the projection phase, a reticle stage carries the patterning means.

The operational sequence of a lithographic apparatus also comprises an exchange phase. During the exchange phase the patterning means is exchanged. In the exchange phase a positioning system positions the patterning means relative to the reticle stage. The positioning system comprises a reticle carrier, which carries the patterning means. The positioning can be performed in different ways, for example by measuring and control or by mechanical docking. After the positioning of the patterning means relative to the reticle stage, the reticle stage takes the patterning means over from the reticle carrier, after which the reticle carrier moves away from the reticle stage. A fixing means fixes the patterning means relative to the reticle stage.

In known lithographic projection systems, the patterning means is carried on top of the reticle stage. However, due to recent developments it has become desirable to locate the patterning means below the reticle stage. This introduces new design problems.

When the patterning means is carried on top of the reticle stage, gravity helps the patterning means to maintain its position relative to the reticle stage. The patterning means generally is placed in a recess of the reticle stage, so that the edges of the recess together with gravity provide the fixing of the patterning means relative to the reticle stage. In the case that the patterning means is carried below the reticle stage, this solution is no longer feasible. Therefore, it has been proposed to fix the patterning means relative to the reticle stage by clamping it to the reticle stage, for example by means of an electrostatic clamp.

Also, the need for interfaces on the patterning means grew stronger, which interfaces could be engaged for handling the patterning means without damaging the sensitive areas of the patterning means. As possible interfaces, brackets at the edges of the patterning means or a frame around the circumference of the patterning means have been proposed, as is described in European Patent Application 02251364.2. As an alternative, the patterning means can be provided with handling zones, which are adapted to be contacted by other machine parts.

However, more problems still had to be overcome. It was found that during the transfer of the patterning means from the reticle carrier to the reticle stage, inaccuracies in the positioning of the patterning means relative to the reticle stage occur.

In addition, the need to reduce idle time has increased with the new developments.

Furthermore, on the one hand, it is advantageous to use a mechanical docking system for positioning the patterning means relative to the reticle stage, as it is reliable, relatively cheap and easy to manufacture. On the other hand, it has turned out that when a mechanical docking system is used, an optimal accuracy of the projected image could not be achieved.

It is a first object of the present invention to provide a lithographic projection apparatus in which the patterning means is taken over from the reticle carrier to the reticle stage in an accurate way.

This object and other objects are according to the first aspect of the invention achieved in a lithographic projection apparatus, comprising:
- a radiation system for providing a projection beam of radiation;
- a patterning means serving to pattern the projection beam according to a desired pattern, thus creating a patterned beam;
- a support structure for supporting the patterning means, the support structure comprising a reticle stage;
- a projection system for projecting the patterned beam onto a target portion of a substrate;
- a positioning means for positioning the patterning means relative to the reticle stage;
   the lithographic projection apparatus having an operational cycle comprising:
   - a projection phase, in which the projection system projects the patterned beam onto a target portion of the substrate, and in which the reticle stage carries the patterning means;
   - and an exchange phase in which the patterning means is exchanged, and in which the positioning means positions the patterning means relative to the reticle stage, the positioning means comprising a reticle carrier;
**characterized in that**
the positioning means comprises coupling means for coupling the reticle carrier with the reticle stage in the exchange phase.

It is essential that the patterning means is positioned accurate relative to the reticle stage, and that the actual position of the patterning means relative to the reticle stage after takeover from the positioning means is fully and precisely known.

In previously known systems, the patterning means was positioned as accurately as possible relative to the reticle stage, and then taken over from the reticle carrier onto the reticle stage. However, due to vibrations in the system, there is relative movement between the reticle carrier and the reticle stage during takeover. The relative displacement between the patterning means and the reticle stage could amount to 50 µm or even more. Due to this relative movement, the actual position of the patterning means relative to the reticle stage has a certain uncertainty and the relative positioning suffers from a loss of accuracy. Moreover, the relative movement causes slip in the patterning means' x-y-plane between the patterning means and the reticle stage. This may cause damage to the patterning means and/or the reticle stage, and generates particles which pollute the environment inside the system. In general, an electrostatic clamp is used as a fixing means to fix the patterning means relative to the reticle stage. Such a clamp is particularly sensitive to damage due to slip of the patterning means (such as scratches) and to the presence of particles between the patterning means and the clamp.

The lithographic projection system according to the first aspect of the invention is provided with coupling means for coupling the reticle carrier with the reticle stage. Due to the coupling of the reticle stage and the reticle carrier, the relative movement between the patterning means, which is carried by the reticle carrier, and the reticle stage is significantly reduced. Therefore, the takeover from the patterning means from the reticle carrier to the reticle stage is far less disturbed by vibrations that cause relative movement and/or slip between the patterning means and the reticle stage.

Preferably, in the lithographic projection system according to the first aspect of the invention, the reticle carrier of the positioning means is provided with an intermediate body. The intermediate body can for example be designed as a plate, or alternatively as an assembly of three spring mounted rods, in which the ends of the rods define a plane for the reticle. During the positioning of the patterning means relative to the reticle stage -which takes place in the exchange phase- , the patterning means is connected to this intermediate body in six degrees of freedom. This can for example be achieved by clamping (either mechanically or electrostaticly), by making use of gravity and friction, or by the use of magnets. Of course, the intermediate body is adapted to release the patterning means during the takeover of the patterning means by the reticle stage. In this embodiment, the coupling means are adapted to provide a coupling between the reticle stage and the intermediate plate.

The coupling of the reticle carrier and the reticle stage can be achieved in various ways. First, the coupling can be mechanical. In that case, the coupling means preferably comprise mechanical docking means.

In a preferred embodiment the mechanical docking means comprises one or more positioning elements arranged on the reticle stage, the one or more positioning elements being spaced from the patterning means during the projection phase. The advantage of such preferred embodiment as well as further preferred embodiments thereof will be described hereinafter in relation with the third object of the invention.

In another preferred embodiment, the mechanical docking means comprises positioning elements having an at least partly spherical positioning face, cooperating with V-shaped grooves. Some elements of the docking means are provided in the reticle stage, while others are provided in the reticle carrier, or preferably in the intermediate body thereof. In this embodiment, the reticle stage is brought into direct contact with the reticle carrier, or preferably with the intermediate body thereof. Thus the reticle carrier, or preferably the intermediate body thereof, is coupled with the reticle stage in six degrees of freedom, eliminating relative movement of the reticle stage and the reticle carrier, or preferably the intermediate body thereof.

As an alternative way of coupling, eddy current can be used. In that case, a magnetic field is generated around the reticle stage and the reticle carrier, which in this embodiment is made of an electrical conductive material. When the reticle carrier moves through the magnetic field, eddy currents occur in the reticle carrier. Due to these eddy currents, the vibration of the reticle carrier is damped. This way, the reticle carrier is coupled to the reticle stage in the sense that the relative movement between the reticle carrier and the reticle stage is very small or even zero.

In a third embodiment, the movements of the reticle stage and the reticle carrier are electronically coupled, using coupling means that comprise measuring means for measuring the relative position of the patterning means and the reticle stage, and control means for controlling the relative position of the patterning means and the reticle stage. In this embodiment, the position of the reticle carrier is measured during the positioning process. In addition, the control means actuate the reticle stage to make it follow the movements of the reticle carrier. This way, the relative movement between reticle carrier and the reticle stage is made very small or even zero. The system can also work the other way around: measuring the position of the reticle stage and actuating the reticle carrier accordingly.

In a preferred embodiment, the position of the patterning means relative to the reticle stage is measured once the reticle carrier has been coupled to the reticle stage. Based on the outcome of this measurement, one or more correction movements are carried out in order to obtain an optimized positioning of the patterning means relative to the reticle stage. When this optimized position is reached, the reticle stage takes over the patterning means from the reticle carrier.

In a preferred embodiment, the reticle stage comprises a long stroke unit for moving the patterning means over large distances, and a short stroke unit for moving the patterning means over small distances. The reticle carrier is the preferably coupled to the long stroke unit of the reticle stage. In that case, the correction movement can be carried out by the short stroke unit. In an alternative embodiment, it can be the other way around: coupling the reticle carrier to the short stroke unit of the reticle stage and performing correction movement with the long stroke unit..

As an alternative for using either the short stroke unit or the long stroke unit for the correction movements, dedicated actuators can be used. Such actuators can for example be mounted on the reticle carrier or on the reticle stage.

In a preferred embodiment, the coupling means is provided with three positioning elements, that are connected to the long stroke unit of the reticle stage. Each of the positioning elements has an at least partly spherical positioning face, which is adapted to interact with a respective V-shaped groove in the intermediate body. Together, the positioning faces of the positioning elements position the intermediate body in the x-y-plane (that is: parallel to the plane of the patterning means), at a known distance in z-direction (that is: perpendicular to the plane of the patterning means) from the reticle stage. The positioning faces and the V-shaped grooves also maintain the position of the intermediate body relative to the reticle stage. Alternative embodiments, in which the coupling means determines the position of the intermediate body in a different plane, at a distance in a different direction from the reticle stage are also envisaged.

In a preferred embodiment, the fixing means of the reticle stage moves towards the patterning means to grab the patterning means.

It is also envisaged that this principle of coupling before takeover of an entity from one unit to an other can be used in different parts of a lithographic apparatus, such as in connection with a wafer stage, for example during a substrate exchange process.

In a lithographic projection system according to the first aspect of the invention, the patterning means is preferably not provided with interfaces such as brackets or a frame.

According to a first further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section thus creating a patterned beam;
- projecting the patterned beam of radiation onto a target portion of the layer of radiation-sensitive material in a projection phase;
- using a reticle stage for carrying and the patterning means;
- exchanging the patterning means in an exchange phase;
- positioning the patterning means relative to the reticle stage in the exchange phase, by using positioning means comprising a reticle carrier;
**characterized by**
- coupling the reticle carrier with the reticle stage in the exchange phase.

It is a second object of the invention to provide a lithographic system in the idle time of the projection system is reduced.

This object and other objects are according to the second aspect of the invention achieved in a lithographic projection apparatus, comprising:
- a radiation system for providing a projection beam of radiation;
- a patterning means serving to pattern the projection beam according to a desired pattern, thus creating a patterned beam;
- a support structure for supporting the patterning means, the support structure comprising a reticle stage;
- a projection system for projecting the patterned beam onto a target portion of a substrate;
- a positioning means for positioning the patterning means relative to the reticle stage,
   the lithographic projection apparatus having an operational cycle comprising:

- a projection phase, in which the projection system projects the patterned beam onto a target portion of the substrate, and in which the reticle stage carries the patterning means;
- and an exchange phase in which the patterning means is exchanged, and in which the positioning means positions the patterning means relative to the reticle stage, the reticle stage being adapted to perform a loading stroke in the exchange phase, which loading stroke extends between an operational area for the patterning means and an exchange area for the patterning means,
**characterized in that**
the apparatus further comprises:
first measuring means for measuring the position of the reticle stage in the plane of the patterning means, the first measuring means comprising an x-sensor that measures the position of the reticle stage in the direction perpendicular to the direction of the loading stroke, the x-sensor being able to measure the position of the reticle stage in the operational area as well as in the exchange area.

The second object and other objects are according to the second aspect of the invention also achieved in a lithographic projection apparatus, comprising:
- a radiation system for providing a projection beam of radiation;
- a patterning means serving to pattern the projection beam according to a desired pattern, thus creating a patterned beam;
- a support structure for supporting the patterning means, the support structure comprising a reticle stage;
- a projection system for projecting the patterned beam onto a target portion of a substrate;
- a positioning means for positioning the patterning means relative to the reticle stage,
   the lithographic projection apparatus having an operational cycle comprising:

- a projection phase, in which the projection system projects the patterned beam onto a target portion of the substrate, and in which the reticle stage carries the patterning means;
- and an exchange phase in which the patterning means is exchanged, and in which the positioning means positions the patterning means relative to the reticle stage, the reticle stage being adapted to perform a loading stroke in the exchange phase, which loading stroke extends between an operational area for the patterning means and an exchange area for the patterning means,
**characterized in that**
the apparatus further comprises:
second measuring means for measuring the position of the reticle stage perpendicular to the plane of the patterning means, the second measuring means comprising a z-sensor, the z-sensor being able to measure the position of the reticle stage in the operational area as well as in the exchange area.

Preferably, the lithographic apparatus comprises both first measuring means for measuring the position of the reticle stage in the plane of the patterning means, the first measuring means comprising an x-sensor that measures the position of the reticle stage in the direction perpendicular to the direction of the loading stroke, and second measuring means for measuring the position of the reticle stage perpendicular to the plane of the patterning means, the second measuring means comprising a z-sensor.

During the projection phase, the patterning means is in an operational area. Any displacements of the patterning means, whether due to operational movements or to disturbances such as vibrations, are measured.

In the exchange area, a patterning means is unloaded from the reticle stage during the exchange phase, and an other patterning means is loaded to the reticle stage. This exchange of patterning means usually takes place outside of the operational area of the patterning means, for otherwise the projection system would be in the way, or the projection system could be damaged if something goes wrong in the exchange process.

In known lithographic systems, an x-sensor measures the position of the reticle stage in the plane of the patterning means in the direction perpendicular to the direction of the loading stroke when the patterning means is displaced inside the operational area. The direction perpendicular to the direction of the loading stroke is the x-direction; the direction of the loading stroke is the y-direction. The plane formed by the x-and y-direction (the x-y-plane) is the plane of the patterning means. For measuring the position of the reticle stage in the x-direction in the exchange area, a separate x-sensor is required.

In known lithographic systems, a z-sensor measures the position of the reticle stage in the direction perpendicular to the plane of the patterning means when the patterning means is displaced inside the operational area. The direction perpendicular to the plane of the patterning means is the z-direction. For measuring the position of the reticle stage in the z-direction in the exchange area, a separate z-sensor is required.

It has been found that the use of separate x- and z-sensors for the exchange area leads to additional idle time of the projection system. When a patterning means has to be exchanged, the reticle stage brings it form the operational area to the exchange area. As the x- and/or the z-sensor loses contact with the reticle stage, it switches off. As soon as the exchange area x- and/or z-sensor detects the reticle stage, it switches on. Then, the first pattering means is exchanged for a second patterning means.

When the second patterning means has been loaded to the reticle stage, the reticle stage takes the pattering means to the operational area. As the reticle stage re-enters the operational area, the x-and/or z-sensor for the operational area has to be restarted and calibrated before the projection system can begin the projection process. Otherwise, the required accuracy of the measurements of the x-position and/or the z-position of the patterning means in the projection area cannot be guaranteed.

So, when there are separate x- and/or z-sensors for the operational area and the exchange area, per measuring direction two sensor starts and a sensor calibration cycle have to be performed during the patterning means exchange process. During this, the projection system is idle.

The sensor restarts and sensor calibrations can be eliminated when the measurement of the x-position of the reticle stage is carried out by the same x-sensor in both the operational area and the exchange area, and when the measurement of the z-position of the reticle stage is carried out by the same z-sensor in both the operational area and the exchange area. This way, the idle time of the projection system can be reduced.

According to the third aspect of the invention, this is achieved by arranging the exchange area closer to the operational area (as compared to known lithographic apparatus), preferably overlapping, such that the same x-sensor and/or z-sensor can be used for measuring the position of the reticle stage in both areas, or by providing means with which it becomes possible to use a single sensor for measuring the position of the reticle stage in the operational and in the exchange area.

An additional advantage of arranging the exchange area closer to the operational are is that the total stroke of the reticle stage is reduced. This is particularly advantageous lithographic projection systems in which the projection process takes place in vacuum, since in this case the dimensions of the vacuum chamber can be reduced also.

Preferably, the x-sensor and/or the z-sensor comprises an interferometer. In that case, it has been observed that the takeover of the patterning means from a positioning system to the reticle stage is performed more accurately than in known lithographic projection apparatus.

It is essential to the apparatus according to the third aspect of the invention that the x- and/or the z-sensor set do not loose contact with the reticle stage during the patterning means exchange process, and that the sensors do not need to be restarted, nor calibrated during the patterning means exchange process. This however does not imply that the x-sensor and/or the z-sensor have to be carried out as single sensors. Assembled sensor sets are also deemed possible.

It is envisaged that the principle of the second aspect of the invention is also applied to other parts of a lithographic apparatus, such as a substrate table.

According to a second further aspect of the invention there is provided a device manufacturing method, comprising the steps of:
- providing a substrate that is at least partially covered by a layer of radiation-sensitive material;
- providing a projection beam of radiation using a radiation system;
- using patterning means to endow the projection beam with a pattern in its cross-section thus creating a patterned beam;
- projecting the patterned beam of radiation onto a target portion of the layer of radiation-sensitive material in a projection phase;
- using a reticle stage for carrying and the patterning means;
- exchanging the patterning means in an exchange phase, the reticle stage being adapted to perform a loading stroke during the exchange phase, which loading stroke extends between an operational area for the patterning means and an exchange area for the patterning means;
characterized by
measuring the position of the reticle stage in the plane of the patterning means using first measuring means, the first measuring means comprising an x-sensor that measures the position of the reticle stage in the direction perpendicular to the direction of the loading stroke,
the x-sensor being able to measure the position of the reticle stage in the operational area as well as in the exchange area.

According to a second further aspect of the invention there is also provided a device manufacturing method, comprising the steps of:
- providing a substrate that is at least partially covered by a layer of radiation-sensitive material;
- providing a projection beam of radiation using a radiation system;
- using patterning means to endow the projection beam with a pattern in its cross-section thus creating a patterned beam;
- projecting the patterned beam of radiation onto a target portion of the layer of radiation-sensitive material in a projection phase;
- using a reticle stage for carrying and the patterning means;
- exchanging the patterning means in an exchange phase, the reticle stage being adapted to perform a loading stroke during the exchange phase, which loading stroke extends between an operational area for the patterning means and an exchange area for the patterning means;
**characterized by**
measuring the position of the reticle stage perpendicular to the plane of the patterning means using second measuring means, the second measuring means comprising a z-sensor, the z-sensor being able to measure the position of the reticle stage in the operational area as well as in the exchange area.

It is a third object of the present invention to provide a lithographic system in which mechanical docking is used for positioning the patterning means relative to the reticle stage, but in which the accuracy of the image projected on the substrate is increased in comparison to known lithographic systems using mechanical docking.

This object and other objects are according to the third aspect of the invention achieved in a lithographic projection apparatus, comprising:
- a radiation system for providing a projection beam of radiation;
- a patterning means serving to pattern the projection beam according to a desired pattern, thus creating a patterned beam;
- a support structure for supporting the patterning means, the support structure comprising a reticle stage;
- a projection system for projecting the patterned beam onto a target portion of a substrate;
- a docking system for positioning the patterning means relative to the reticle stage;
   the lithographic projection apparatus having an operational cycle comprising:
   - a projection phase, in which the projection system projects the patterned beam onto a target portion of the substrate, and in which the reticle stage carries the patterning means;
   - and an exchange phase in which the patterning means is exchanged, and in which the docking system positions the patterning means relative to the reticle stage;
**characterized in that**
the docking system comprises one or more positioning elements arranged on the reticle stage and in that the one or more positioning elements are spaced from the patterning means during the projection phase.
As the one more positioning elements of the docking system are spaced from (that is: free of physical contact with) the patterning means during the projection phase, in the lithographic projection apparatus according to the third aspect of the invention the patterning means is not subjected to any force originating from the docking system in the projection phase. As a consequence, no deformation or deflection is induced by the docking system during the projection of the image on the substrate, which results in an increased accuracy of the projection of the image on the substrate.

In a preferred embodiment, the docking system comprises a reticle carrier, which is provided with at least one support. The docking system further comprises one or more positioning elements, which are preferably connected to the reticle stage. The support of the reticle carrier is adapted to position the patterning means relative to the reticle carrier accurately and reproducibly. So, the position of the patterning means relative to the reticle carrier in general, and more particular the position of the patterning means relative to the support, is known.

By then positioning the reticle carrier, or at least the part thereof that actually carries the pattering means such as the support, accurately relative to the reticle stage, the patterning means is consequently also positioned accurately relative to the reticle stage.

In known lithographic apparatus, the reticle carrier just brings the patterning means near the reticle stage. When the patterning means comes close enough to the reticle stage, positioning elements connected to the reticle stage engage the patterning means, and then force the patterning means into the right position. This positioning of course has to take place before the patterning means can be fixed, so during this positioning the patterning means is in contact with the reticle carrier as well as with elements connected to the reticle stage. When the patterning means reaches its final position relative to the reticle stage, fixing means fix the patterning means relative to the reticle stage and the reticle carrier releases the patterning means and moves away. During the projection phase, the positioning elements connected to the reticle stage stay in physical contact with the patterning means.

However, in the lithographic apparatus according to the invention, the positioning of the patterning means takes place in a more indirect way: first the patterning means is positioned relative to the reticle carrier, and then the reticle carrier is positioned relative to the reticle stage. As now, instead of the patterning means, the reticle carrier is positioned relative to the reticle stage, the positioning elements connected to the reticle stage engage the reticle carrier instead of the patterning means. This way, the positioning elements do not need to engage the patterning means for positioning the patterning means relative to the reticle stage.

As the reticle carrier is in a position away from the reticle stage during the time the projection system is active, the docking system (which comprises the positioning elements connected to the reticle stage) is free of contact from the patterning means during the projection of the image on the substrate, so it does not introduce any deflection of the patterning means during the projection phase.

In a preferred embodiment, each support of the reticle carrier has a first positioning face, and each positioning element has a second positioning face. The first positioning face interacts with a respective second positioning face in order to position the support of the reticle carrier and thus the patterning means relative to the reticle stage. Once the reticle carrier is close enough to its final position in the x-y-plane (that is: in the plane of the patterning means), the respective first and second positioning faces contact each other and move the support on the reticle carrier - and the patterning means with it - to its final position in the x-y-plane. Preferably, each support and each positioning element is spring-mounted, in such a way that the support has the freedom to move in the three translational directions, and the positioning element can only move in the translational direction substantial perpendicular to the plane of the patterning means (z-direction). This ensures a reproducible and accurate positioning, since the interacting positioning faces will move the patterning means to its desired position in the x-y-plane by the interaction of the first and second positioning faces. After that, the reticle carrier moves the patterning means in the z-direction towards the projection system, so the clamp can take over the patterning means from the reticle carrier. This ensures a reproducible and accurate positioning of the patterning means relative to the reticle stage.

So, the patterning means first reaches its final position in the x-y-plane , before it is moved in z-direction to the reticle stage and clamped to the reticle stage. It is advantageous that movement of the patterning means in the x-y-plane is avoided when clamping the patterning means, since such a relative movement of the patterning means and the reticle stage may cause damage to the patterning means. It is however envisaged that that the patterning means is first brought into a final position in a plane different then its x-y-plane, after which it is moved into its final position relative to the reticle stage by means of a movement in other than its z-direction.

In a preferred embodiment, the reticle carrier comprises three supports, each support having a partly spherical carrying face for carrying the patterning means. An interface of the reticle, such as a frame or a plurality of brackets, comprises three conical holes or V-shaped grooves, in which the respective carrying faces engage the patterning means. The patterning means is thus positioned accurately relative to the reticle carrier.

In this preferred embodiment, each support may comprises a hole, which is at least partly conical. The wall of this conical part forms the first positioning face. The positioning elements have at least partly a pinform shape, with a partly spherical tip area, which tip area forms the second positioning surface. The dimensions of the spherical tip area and the conical part of the hole are chosen such that the tip area fits inside the conical hole, and that it contacts the wall of the hole in a reproducible way.

The interface of the patterning means is provided with holes or grooves having a larger diameter or width, respectively, than the pinform parts of the positioning elements. The holes or grooves are arranged such that when the patterning means approaches its final position, the positioning elements project through them. In that situation, each spherical tip area of the positioning means engages the wall of the conical part of the hole in a respective support. As the support has the freedom to move in the three translational directions, and the positioning element can only move in the translational direction substantial perpendicular to the plane of the patterning means, the positioning elements move the supports (and thus the patterning means with them) to their final position in the plane of the patterning means. The patterning means is thus positioned in a reproducible and accurate way relative to the reticle stage.

Finally, a translatory movement in the direction substantially perpendicular to the plane of the patterning means allows the clamp to take over the patterning means from the reticle carrier. The reticle carrier moves away from the patterning means once the clamp has taken over.

This preferred embodiment provides a construction of simple design, which is easy to manufacture and which has the merits of the apparatus according to the third aspect of the invention.

In an alternative embodiment for the third object of the invention, the one or more positioning elements are movably connected to the reticle stage, the one or more positioning elements being movable between an exchanging position wherein the one or more positioning elements are in contact with a patterning means placed on the reticle stage, and a projection phase position wherein the one or more positioning elements are spaced from the patterning means placed on the reticle stage.

In such alternative embodiment the patterning means can be directly positioned on the positioning elements in the exchange phase position (thus not via the reticle carrier). After the patterning means is clamped, the one or more positioning elements can be brought in the projection phase position for instance by be retracting the one or more positioning elements in the reticle stage. In that way forces introduced by the one or more positioning elements during the projecting phase are avoided.

In another alternative embodiment it is possible to block the forces introduced by the positioning elements, by blocking the springs of the spring-mounted positioning elements, for instance by bringing a blocking pen in the positioning element.

According to a third further aspect of the invention there is provided a device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section, thus creating a patterned beam;
- projecting the patterned beam of radiation onto a target portion of the layer of radiation-sensitive material in a projection phase;
- using a reticle stage for carrying the patterning means;
- exchanging the patterning means in an exchange phase;
- using a mechanical docking system having one or more positioning elements arranged on the reticle stage to position the patterning means relative to the reticle stage in the exchange phase;
**characterized by**
keeping the one or more positioning elements spaced from the one or more positioning elements during the projection phase.

According to the above features of the different aspects of the invention as claimed in the appended claims 1-12, lithographic apparatuses and methods are described wherein a patterning means is placed on a reticle stage, or wherein the position of a reticle stage is measured. The same features and principles can be applied to place a substrate on which a patterned beam is radiated, on a substrate support, for instance a substrate table, and to measure the position of a substrate support, respectively.

In that case according to the first aspect of the invention a substrate carrier and a substrate support would be coupled with coupling means before placing the substrate on the substrate table. According to the second aspect of the invention, the position of the substrate support would be measured by the same x-sensor and/or z -sensor in both the operational area as the exchange area, and according to the third aspect of the invention one or more positioning elements arranged on the substrate support would be spaced from the substrate placed on the substrate support during the projection phase.

The application of the features of the claims 1-12 on the placement of a substrate on a substrate support or the measurement of the position of the substrate support are regarded to fall within the scope of the appended claims.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet (UV) radiation (e.g. with a wavelength of 365, 248, 193, 157 or 126 nm) and extreme ultra-violet (EUV) radiation (e.g. having a wavelength in the range 5-20 nm), as well as particle beams, such as ion beams or electron beams.

Embodiments of the invention will now be described, by way of example only, with reference to the accompanying schematic drawings in which corresponding reference symbols indicate corresponding parts, and in which:
- Figure 1 depicts schematically a lithographic projection apparatus according to an embodiment of the invention;
- Figure 2 depicts a schematic overview of a relevant part of a lithographic projection apparatus in which the first and third object of the invention have been incorporated;
- Figures 3A,B,C depict a schematic overview of the docking process in a lithographic projection apparatus according to the first and third object of the invention;
- Figure 4 depicts a schematic overview of a relevant part of a lithographic projection apparatus according to the first and third object of the invention;
- Figures 5A,B depict a schematic overview of a relevant part of a lithographic projection apparatus according to the second object of the invention.

### Embodiment 1

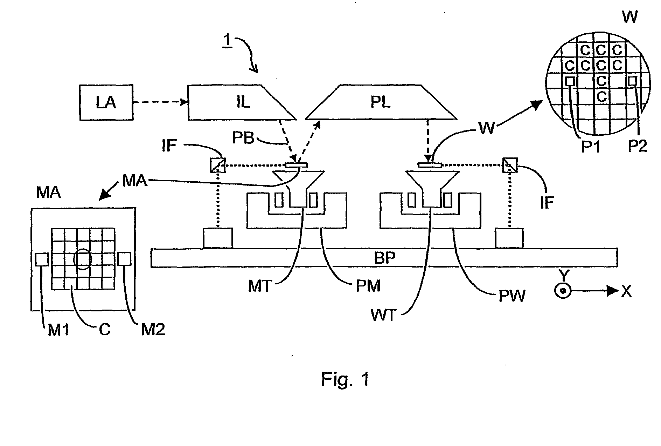

Figure 1 schematically depicts a lithographic projection apparatus 1 according to a particular embodiment of the invention. The apparatus comprises:
- a radiation system Ex, IL, for supplying a projection beam PB of radiation (e.g. EUV radiation). In this particular case, the radiation system also comprises a radiation source LA;
- a first object table (mask table) MT provided with a mask holder for holding a mask MA (e.g. a reticle), and connected to first positioning means PM for accurately positioning the mask with respect to item PL;
- a second object table (substrate table) WT provided with a substrate holder for holding a substrate W (e.g. a resist-coated silicon wafer), and connected to second positioning means PW for accurately positioning the substrate with respect to item PL; and
- a projection system ("lens") PL (e.g. a mirror set) for imaging an irradiated portion of the mask MA onto a target portion C (e.g. comprising one or more dies) of the substrate W.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA (e.g. a laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means PW (and interferometric measuring means IF), the substrate table WT can be moved accurately, e.g. so as to position different target portions C in the path of the beam PB. Similarly, the first positioning means PM can be used to accurately position the mask MA with respect to the path of the beam PB, e.g. after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in figure 1. However, in the case of a wafer stepper (as opposed to a step-and-scan apparatus) the mask table MT may just be connected to a short stroke actuator, or may be fixed. Mask MA and substrate W may be aligned using mask alignment marks M1, M2 and substrate alignment marks P1, P2.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB; and
2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

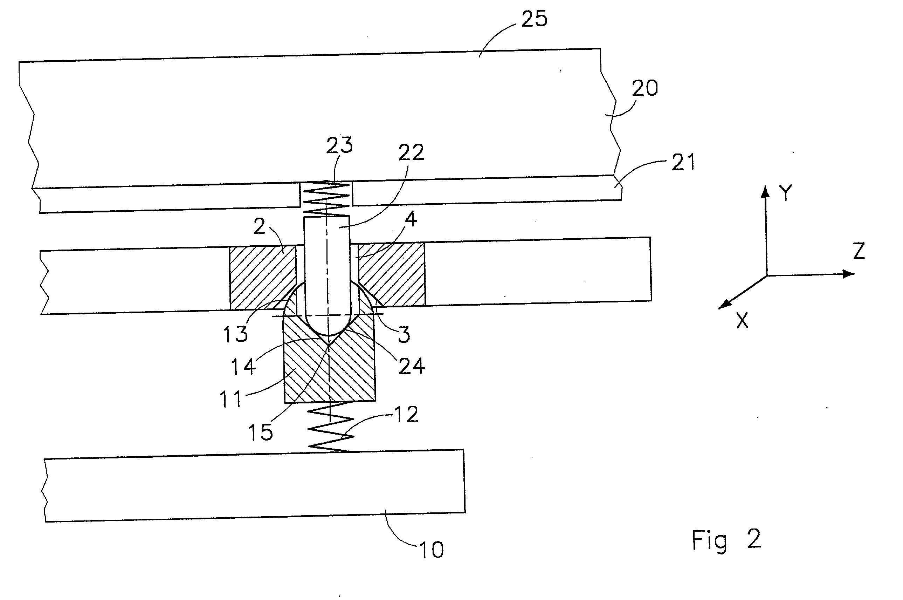

Fig. 2 shows a schematic overview of a relevant part of a lithographic projection apparatus according to the first aspect of the invention. A reference coordinate system, comprising directions x, y and z is indicated in fig. 2. As can be seen, the x-y-plane is the plane of the patterning means (in this case reticle 1), and z is the direction perpendicular to that plane.

In the embodiment of fig. 2, the patterning means used is a reticle 1. This reticle 1 can either be transmissive of reflective. Brackets 2 are provided at at least three locations on the circumference of the reticle 1. Each of the brackets 2 is provided with a cylindrical hole 4 and a V-shaped groove 3.

During positioning of the reticle 1 relative to the reticle stage 25, the reticle 1 is carried by a reticle carrier 10. The reticle carrier 10 comprises three supports 11. Each of the supports 11 is mounted on a spring 12, which allows the support 11 to move in x-, y-and z-direction. Each of the supports has a partly spherical carrying face 13 for carrying the reticle 1. Carrying face 13 is dimensioned in such a way that it fits in V-shaped groove 3 of the respective reticle bracket 2. Due to the interaction between V-shaped groove 3 and carrying face 13, the reticle 1 is positioned accurately and reproducibly relative to the supports of the reticle carrier 10. Each of the supports 11 is provided with a first positioning face 14, which is in this case the conical wall part of hole 15.

The docking system comprises three positioning elements 22. Each of the positioning elements 22 is spring-mounted, as is schematically represented by spring 23. The positioning elements 22 are mounted in such a way that they can only move in z-direction. This can for example be achieved by mounting each of the positioning elements 22 on two mutually parallel leaf springs.

Each of the positioning elements 22 is attached to the mirror block 20, which forms a part of reticle stage 25. At the mirror block a clamp 21, which is for example an electrostatic clamp, is present for fixing the reticle 1 relative to the mirror block 20.

Each of the positioning elements 22 is provided with a second positioning face 24, which is in this case a partly spherical tip area. Second positioning face 24 is dimensioned in such a way that it fits in hole 15 of the respective support 11. Due to the interaction between second positioning face 24 and first positioning face 14, the supports 11 are positioned accurately and reproducibly relative to the positioning elements 22. As the reticle 1 is positioned accurately and reproducibly relative to the supports, the reticle 1 is also positioned accurately and reproducibly relative to the positioning elements 22, and thus to the reticle stage 25.

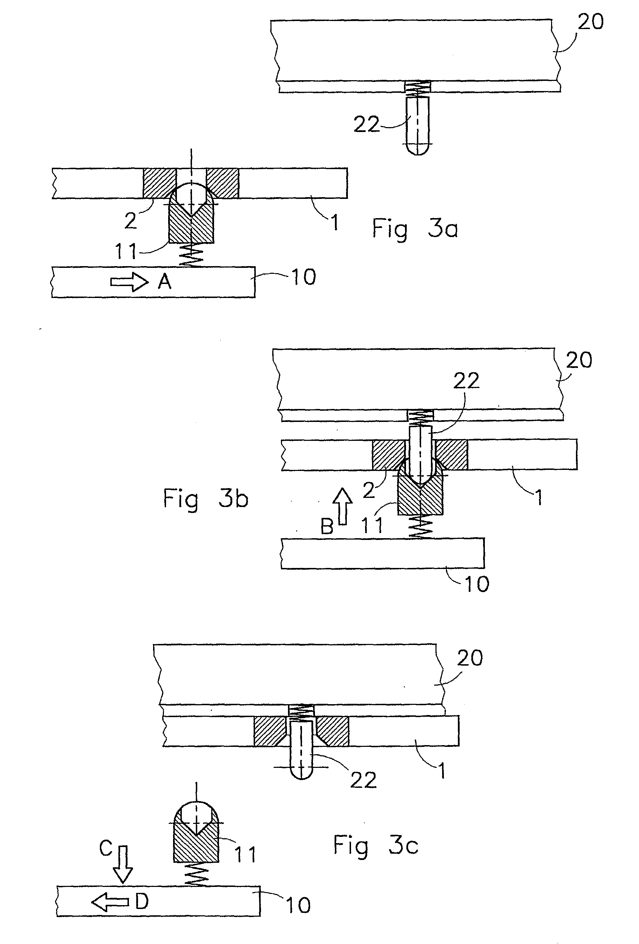

In operation, the reticle 1 is placed onto the supports 11, in such a way that the carrying faces 13 are in contact with the walls of the V-shaped grooves 3 (cf. fig. 3A). The reticle carrier 10 which now carries the reticle 1 is then moved towards the mirror block 20. This movement takes place mainly in the x-y-plane (arrow A in fig. 3A).

When the reticle 1 approaches its docking position, the positioning elements 22 move through the holes 4 on the brackets 2, and under the influence of the springs 23, the positioning elements 22 will come to project through the holes 4, each into the hole 15 of each respective support 11 (cf. fig. 3B).

As the positioning elements 22 can only move in z-direction, they move the supports 11 in the x-y-plane until each second positioning surface 24 has "found" its respective first positioning face 14, that is in this case when each second positioning surface 24 is in contact with its respective first positioning surface 14 at at least three points over its circumference, so that an equilibrium of forces is achieved (such as shown in fig. 2). Then, the reticle 1 has reached its final position in the x-y-plane.

After positioning the reticle 1 in the x-y-plane, the reticle carrier 10 moves in z-direction towards the mirror block 20 (arrow B in fig. 3B). The supports 11 take the positioning elements 22 along with them in z-direction, which is allowed by the springs 23. When the reticle 1 has reached its final position in z-direction too, the clamp 21 becomes active, and fixes the reticle 1 relative to the mirror block 20. The reticle carrier 10 is then withdrawn, first moving away from the mirror block 20 in z-direction, and then moving out of the way of the projection system substantially in the x-y-plane (cf. fig. 3C, arrows C and D). Now, the docking system is ready for the projection system to become active.

As is clear from fig. 2, the diameter of the positioning element 22 (for which in the shown embodiment a pinform element is used), is significantly smaller that the diameter of the hole 4 through which it projects. This is essential to the apparatus according to the first aspect of the invention, since in this way the docking system is free of contact from the reticle when the projection system is active. So, the docking system does not apply any mechanical load onto the reticle when the projection system is active, and therefore the docking system causes no deflection or deformation of the reticle. This improves the accuracy of the projected image.

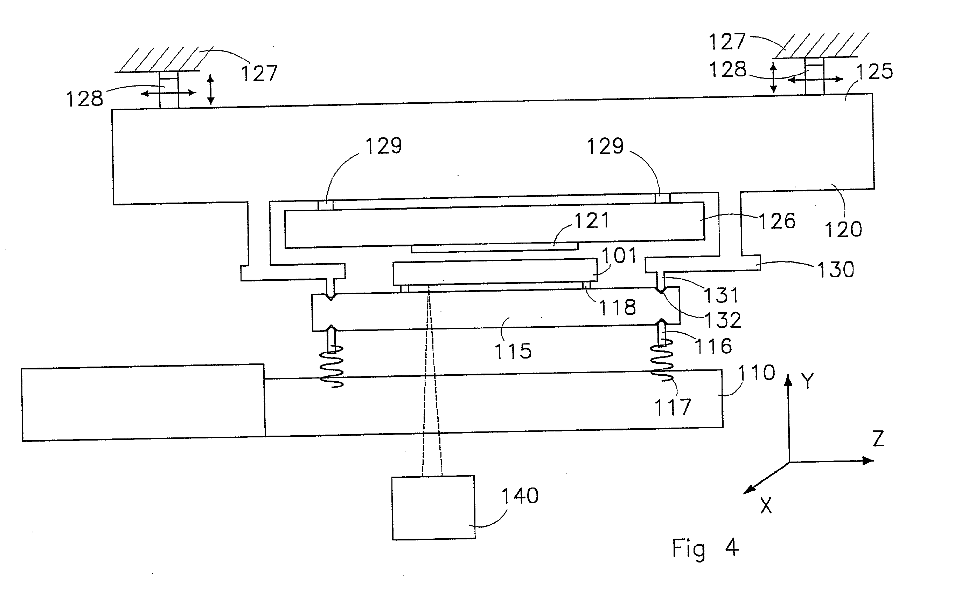

Fig. 4 depicts a schematic overview of a relevant part of a lithographic projection apparatus according to the second aspect of the invention.

Fig. 4 shows a reticle stage 120 for moving the reticle 101 relative to the projection system. The reticle stage 120 comprises a long stroke unit 125 and a short stroke unit 126. Between the long stroke unit 125 and the short stroke unit there are connections 129, that allow movement of the short stroke unit 126 relative to the long stroke unit 125. The short stroke unit 126 comprises a clamp 121 for fixing the reticle 101 relative to the reticle stage 120. The reticle stage is connected to supports 127 via connections 128, that allow movement of the reticle stage 120 relative to the supports 127.

According to the second aspect of the invention, the apparatus further comprises positioning means, for positioning the reticle 101 relative to the reticle stage 120. The positioning means comprise a reticle carrier 110 with an intermediate body 115, which in the shown embodiment is a spring mounted plate. Supports 116, each mounted on a spring 117 carry the intermediate body 115.The reticle 101 is connected with the intermediate body 115 in six degrees of freedom during the positioning of the reticle 101 relative to the reticle stage 120. The connection means 118 between the reticle 101 and the intermediate body 115 can be for example a mechanical or electrostatic clamp, a magnet system or a system that uses a combination of gravity and friction. Of course, the connection means 118 between the intermediate body 115 and the reticle 101 is switched off during the takeover of the reticle 101 by the reticle stage.

Also, the apparatus according to the second aspect of the invention comprises coupling means 130 for coupling the intermediate body 115 with the reticle stage 120. Due to the coupling of the reticle stage 120 and the intermediate body 115, the relative movement between the reticle 101 and the reticle stage 120 is significantly reduced or even turned to zero. Therefore, the takeover from the reticle 101 from the reticle carrier 110 to the reticle stage 120 is far less disturbed by vibrations that cause relative movement and/or slip between the reticle 101 and the reticle stage 120.

In the embodiment shown in fig. 4, the coupling means comprise mechanical docking means, more in particular positioning elements 131 connected to the reticle stage and having an at least partly spherical positioning face, and V-shaped grooves 132 in the intermediate body 115. In this embodiment, the positioning elements 131 and the V-shaped grooves 132 together provide direct contact between the reticle stage 130 and the intermediate body 115. This way the reticle stage 120 and the intermediate body 115 are coupled in six degrees of freedom, thus eliminating relative movement.

In the embodiment of fig. 3, the coupling means 130 comprises three positioning elements 131, that are connected to the long stroke unit 125 of the reticle stage 120. Each of the positioning elements 131 has an at least partly spherical positioning face, which is adapted to interact with a respective V-shaped groove 132 in the intermediate body 115. Together, the positioning faces of the positioning elements 131 position the intermediate body 115 in the x-y-plane (that is: parallel to the plane of the reticle 101), at a known distance in z-direction (that is: perpendicular to the plane of the reticle 101) from the reticle stage 120. The positioning faces and the V-shaped grooves 132 also maintain the position of the intermediate body 115 relative to the reticle stage 120. Alternative embodiments, in which the coupling means determines the position of the intermediate body in a different plane, at a distance in a different direction from the reticle stage are also envisaged.

As an alternative to the mechanical docking means, eddy current coupling means or electronic coupling can be used. Also, electronic coupling is envisaged. In that case, the movements of the reticle stage 101 and the intermediate body 115 are electronically coupled, using coupling means that comprise measuring means for measuring the relative position of the reticle 101 and the reticle stage 120, and control means for controlling the relative position of the reticle 101 and the reticle stage 120. In this embodiment, the position of the intermediate body 115 is measured during the positioning process. In addition, the control means actuate the reticle stage 120 to make it follow the movements of the intermediate body 115. This way, the relative movement between the intermediate body 115 and the reticle stage 120 is made very small or even zero.

In a preferred embodiment, the position of the reticle 101 relative to the reticle stage 120 is measured once the intermediate body 115 has been coupled to the reticle stage 120. For this, a sensor 140 is provided in the embodiment of fig. 3. Based on the outcome of this measurement, one or more correction movements are carried out in order to obtain an optimized positioning of the reticle 101 relative to the reticle stage 120. When this optimized position is reached, the reticle stage 120 takes over the reticle 101 from the intermediate body 115. Preferably, the clamp 121 of the short stroke unit 126 moves towards the reticle 101 in z-direction to grab the reticle 101.

In the embodiment of fig. 4, the intermediate body 115 is coupled to the long stroke unit 125 of the reticle stage 120. In that case, the correction movement is preferably carried out by the short stroke unit 126.

As an alternative for using either the short stroke unit 126 or the long stroke unit 125 for the correction movements, dedicated actuators can be used. Such actuators can for example be mounted on the reticle carrier 110 or on the reticle stage 120.

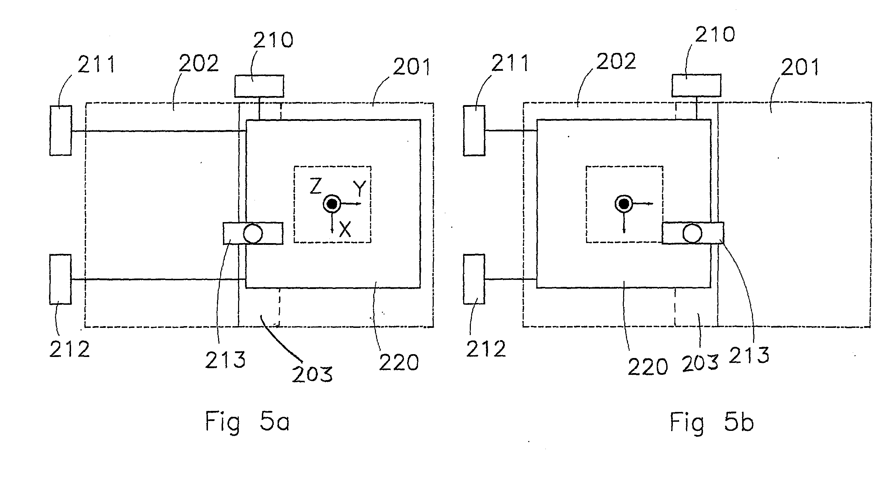

Figure 5A,B depict a schematic overview of a relevant part of a lithographic projection apparatus according to the third aspect of the invention.

Fig. 5A shows the reticle stage 220 in the operational area 201. The position of the reticle stage 220 is measured in the plane of the patterning means (the x-y-plane). The measurement of the reticle stage position in the y-direction is performed by the y-sensors 211 and 212, while the reticle stage position in the x-direction is measured by the x-sensor 210. Based on the measurements of both y-sensors 211 and 212, the rotational position of the reticle stage relative to the z-axis is determined.

Also, the position of the reticle stage 220 perpendicular to the plane of the patterning means is measured. For this, a z-sensor 213 is used.

Fig. 5B shows the reticle stage 220 in the exchange area 202. A single x-sensor 210 measures the x-position of the reticle stage 220 in the operational area 201 as well as in the exchange area 202. Also, a single z-sensor 213 measures the z-position of the reticle stage 220 in both the operational area and the exchange area. In order to achieve this, the exchange area 202 is arranged close to the operational area 201. In the drawings it can be clearly seen that the operational area and the exchange area 202 are overlapping in the overlapping area 203. In this way the same x-sensor 210 and z-sensor 213 can be used to measure the position of the reticle stage in both the operational area 201 and the exchange area 202 in a simple way.

However, if it is not possible to make the operational area 201 and the exchange area 202 overlapping, for instance due to constructional reasons, means can be provided so that the same x-sensor and/or z-sensor can be used for measuring the x-position/z-position, respectively, in the operational area and the exchange area. Such means could comprise extended portions on the reticle stage, movable sensors and directing means for directing the sensor signals such as mirror systems to direct the sensor signals to two different locations, one in the operational area and exchange area.

Preferably the x-sensor, y-sensors and z-sensor are interferometers.

Whilst specific embodiments of the invention have been described above, it will be appreciated that the invention may be practiced otherwise than as described. The description is not intended to limit the invention.

## Claims

1. A lithographic projection apparatus comprising:
- a radiation system for providing a projection beam of radiation;
- a patterning means (1, 101) serving to pattern the projection beam according to a desired pattern, thus creating a patterned beam;
- a support structure for supporting the patterning means, the support structure comprising a reticle stage (25, 120);
- a projection system for projecting the patterned beam onto a target portion of a substrate;
- a positioning means for positioning the patterning means (1, 101) relative to the reticle stage (25, 120),
the lithographic projection apparatus having an operational cycle comprising:
- a projection phase, in which the projection system projects the patterned beam onto a target portion of the substrate, and in which the reticle stage (25, 120) carries the patterning means (1, 101);
- and an exchange phase in which the patterning means (1, 101) is exchanged, and in which the positioning means positions the patterning means (1, 101) relative to the reticle stage (25, 120), the positioning means comprising a reticle carrier (10, 110)
**characterized in that**
the positioning means comprises coupling means (11, 22, 130) for coupling the reticle carrier (10, 110) with the reticle stage (25, 120) in the exchange phase.

2. A lithographic projection apparatus according to claim 1,
**characterized in that**,
the reticle carrier (110) comprises an intermediate body (115), which intermediate body (115) is adapted to be connected with the patterning means (101) in six degrees of freedom,
and **in that** the coupling means (130) are adapted to couple the intermediate body (115) with the reticle stage (120) in the exchange phase.

3. A lithographic projection apparatus according to claim 1 or 2,
**characterized in that**,
the coupling means (11, 22, 130) comprises mechanical docking means.

4. A lithographic projection apparatus according to claim 3,
**characterized in that**,
the mechanical docking means (11, 22, 130) comprises one or more positioning elements (22, 131) arranged on the reticle stage, and **in that** the one or more positioning elements (22, 131 ) are spaced from the patterning means (1, 101) during the projection phase.

5. A lithographic projection apparatus according to claim 2 and 3,
**characterized in that**,
the mechanical docking means comprise three docking elements that are connected to the the reticle stage (120), each of the docking elements having an at least partly spherical positioning face,
and **in that** the intermediate body (115) comprises three V-shaped grooves (132), the three positioning faces and the three V-shaped grooves (132) being adapted to cooperate in positioning the intermediate body (115) relative to the reticle stage (120), and to maintain the position of the intermediate body (115) relative to the reticle stage (120).

6. A lithographic projection apparatus according to claim 1 or 2,
**characterized in that**,
the coupling means comprises eddy current damping means.

7. A lithographic projection apparatus according to claim 1 or 2,
**characterized in that**,
the coupling means comprises measuring means for measuring the relative position of the patterning means (101) and the reticle stage (120), and control means for controlling the relative position of the patterning means (101) and the reticle stage (120).

8. A lithographic projection apparatus according to any of the claims 1-7,
**characterized in that**,
the apparatus further comprises measuring means for measuring the position of the patterning means (101) relative to the reticle stage (120) after coupling the reticle carrier (110) with the reticle stage (120), and correction means for generating one or more correction movements that optimize the relative position of the patterning means (101) relative to the reticle stage (120) after coupling the reticle carrier (110) with the reticle stage (120).

9. A device manufacturing method comprising the steps of:
- providing a substrate that is at least partially covered by a layer of radiation-sensitive material;
- providing a projection beam of radiation using a radiation system;
- using patterning means (1, 101) to endow the projection beam with a pattern in its cross-section thus creating a patterned beam; and
- projecting the patterned beam of radiation onto a target portion of the layer of radiation-sensitive material in a projection phase;
- using a reticle stage (25, 120) for carrying and the patterning means (1, 101);
- exchanging the patterning means (1, 101) in an exchange phase,
- positioning the patterning means (1, 101) relative to the reticle stage (25, 120) in the exchange phase, by using positioning means comprising a reticle carrier (10, 110),
**characterized by**
- coupling the reticle carrier (10, 110) with the reticle stage (25, 120) in the exchange phase.

10. A lithographic projection apparatus comprising:
- a radiation system for providing a projection beam of radiation;
- a patterning means serving to pattern the projection beam according to a desired pattern, thus creating a patterned beam;
- a support structure for supporting the patterning means, the support structure comprising a reticle stage;
- a projection system for projecting the patterned beam onto a target portion of a substrate;
- a positioning means for positioning the patterning means relative to the reticle stage,
the lithographic projection apparatus having an operational cycle comprising:
- a projection phase, in which the projection system projects the patterned beam onto a target portion of the substrate, and in which the reticle stage carries the patterning means;
- and an exchange phase in which the patterning means is exchanged, and in which the positioning means positions the patterning means relative to the reticle stage, the reticle stage being adapted to perform a loading stroke in the exchange phase, which loading stroke extends between an operational area (201 for the patterning means and an exchange area for the patterning means;
**characterized in that**
the apparatus further comprises:
- first measuring means for measuring the position of the reticle stage in the plane of the patterning means, the first measuring means comprising an x-sensor that measures the position of the reticle stage in the direction perpendicular to the direction of the loading stroke, the x-sensor being able to measure the position of the reticle stage in the operational area as well as in the exchange area,
and/or
- second measuring means for measuring the position of the reticle stage perpendicular to the plane of the patterning means, the second measuring means comprising a z-sensor,
the z-sensor being able to measure the position of the reticle stage in the operational area as well as in the exchange area.

11. A device manufacturing method comprising the steps of:
- providing a substrate that is at least partially covered by a layer of radiation-sensitive material;
- providing a projection beam of radiation using a radiation system;
- using patterning means to endow the projection beam with a pattern in its cross-section thus creating a patterned beam;
- projecting the patterned beam of radiation onto a target portion of the layer of radiation-sensitive material in a projection phase;
- using a reticle stage for carrying and the patterning means;
- exchanging the patterning means in an exchange phase, the reticle stage being adapted to perform a loading stroke during the exchange phase, which loading stroke extends between an operational area for the patterning means and an exchange area for the patterning means;
**characterized by**
- measuring the position of the reticle stage in the plane of the patterning means using first measuring means, the first measuring means comprising an x-sensor that measures the position of the reticle stage in the direction perpendicular to the direction of the loading stroke, the x-sensor being able to measure the position of the reticle stage in the operational area as well as in the exchange area,
and/or
- measuring the position of the reticle stage perpendicular to the plane of the patterning means using second measuring means, the second measuring means comprising a z-sensor, the z-sensor being able to measure the position of the reticle stage in the operational area as well as in the exchange area.

12. A lithographic projection apparatus comprising:
- a radiation system for providing a projection beam of radiation;
- a patterning means (1, 101) serving to pattern the projection beam according to a desired pattern, thus creating a patterned beam;
- a support structure for supporting the patterning means (1, 101), the support structure comprising a reticle stage (25, 120);
- a projection system for projecting the patterned beam onto a target portion of a substrate;
- a mechanical docking system for positioning the patterning means (1, 101) relative to the reticle stage (25, 120),
the lithographic projection apparatus having an operational cycle comprising:
- a projection phase, in which the projection system projects the patterned beam onto a target portion of the substrate, and in which the reticle stage (25, 120) carries the patterning means (1, 10 1);
- and an exchange phase in which the patterning means (1, 101) is exchanged, and in which the docking system positions the patterning means (1, 101 ) relative to the reticle stage (25, 120);
**characterized in that**
the docking system (11, 22, 130) comprises one or more positioning elements (22, 131) arranged on the reticle stage (25, 120) and **in that** the one or more positioning elements are spaced from the patterning means (1, 101) during the projection phase.
